# EUROPÄISCHE PATENTSCHRIFT

(11) **EP 1 228 565 B1**
(45) Veröffentlichungstag und Bekanntmachung des Hinweises auf die Patenterteilung: **30.04.2014**
(21) Anmeldenummer: 00993062.9
(22) Anmeldetag: 08.11.2000
(51) Int. Cl.: H03K 17/74

(54) **PIN-DIODEN-SCHALTANORDNUNG**
PIN DIODE CIRCUIT ARRANGEMENT
CIRCUIT A DIODE PIN

(30) Priorität: 09.11.1999 DE 19953872
(43) Veröffentlichungstag der Anmeldung: 07.08.2002
(73) Patentinhaber: QUALCOMM Incorporated, San Diego, CA 92121-1714 (US)
(72) Erfinder: HERZBERG, Ralf, 47918 Tönisvorst (DE)
(74) Vertreter: Samson & Partner
(86) Internationale Anmeldenummer: PCT/DE2000/003906
(87) Internationale Veröffentlichungsnummer: WO 2001/035530

(56) Entgegenhaltungen:
- EP-A- 0 578 160
- US-A- 5 634 200
- HAMMES B: "RF HIGH POWER SWITCH WITH REVERSE BIASED PIN-DIODES" MOTOROLA TECHNICAL DEVELOPMENTS,US,MOTOROLA INC. SCHAUMBURG, ILLINOIS, Bd. 23, 1. Oktober 1994 (1994-10-01), Seiten 32-33, XP000468371

## Beschreibung

Die Erfindung betrifft eine PIN-Dioden-Schaltanordnung, insbesondere realisiert in der Sendestufe eines Mobilfunktelefons oder als Umschalter für die Antenne zwischen Senden und Empfangen.

PIN-Dioden werden im Hochfrequenzbereich als regelbarer Widerstand für Dämpfungszwecke und als verlustarme Schalter eingesetzt. Der Einsatz der PIN-Dioden im Hochfrequenzgebiet ist aufgrund der kleinen Diodenabmessungen, der geringen Einfügungsinduktivität und der niedrigen Sperrkapazität gegeben.

Es ist bekannt, daß PIN-Dioden, die große Hochfrequenz-Leistungen schalten müssen (HF-Schalter), im gesperrten Zustand mit einer negativen Sperrspannung vorgespannt werden müssen, die mindestens die Höhe der zu schaltenden Hochfrequenzspannung (Spitzenspannung) hat, um Signalverzerrungen, Oberwellenbildung und Hochfrequenzdämpfung zu vermeiden. Beispielsweise wird eine 14 V Vorspannung benötigt, um 2 Watt HF-Leistung in einem Mobilfunktelefon mit 3,6 V Versorgungsspannung zu schalten.

Für die Erzeugung der notwendigen negativen Sperrspannung wurden bisher die üblichen Gleichspannungswandler eingesetzt, wie z. B. Schaltwandler oder Ladungspumpen (geschaltete Kondensatoren).

Die Erzeugung der relativ hohen negativen Spannung mit dem Gleichspannungswandler insbesondere für batteriebetriebenen Geräte ist also mit einem hohen Aufwand sowie mit hohen Kosten verbunden, die dem Gleichspannungswandler zugeführte Hilfenergie setzt außerdem die Betriebszeit eines batteriebetriebenen Gerätes herab.

Darüber hinaus hat der Spannungswandler in einer Schaltungsanordnung einen im Vergleich zu den Abmessungen der heutigen elektronischen Geräte und insbesondere Mobilfunktelefone erheblichen Raumbedarf, was der Tendenz und der wirtschaftlichen Notwendigkeit, kleiner dimensionierte und handlichere Mobilfunktelefone zu bauen, entgegensteht.

Die EP 0 578 160 A1 offenbart eine Antennenumschaltvorrichtung zum selektiven Verbinden einer Antenne mit einem Empfängen bzw. einem Sender. Die Antennenumschaltvorrichtung umfasst eine zum Signalpfad in Reihe geschaltete gleichstrom gesteuerte PIN- Diode als Umschalter. Aufgabe der vorliegenden Erfindung ist es daher, eine neuartige und wirkungsvolle Schaltungsanordnung der gattungsgemäßen Art anzugeben, die kostengünstig und ohne großen Aufwand realisierbar ist.

Diese Aufgabe wird durch eine Schaltungsanordnung mit den Merkmalen des Anspruches 1 gelöst.

Die Erfindung schließt den wesentlichen Gedanken ein, um den (Gleichricht-)Stromfluß und die damit verbundene Oberwellenbildung und Hochfrequenzdämpfung aus einer zum Signalpfad parallel geschalteten PIN-Diode zu unterdrücken, die PIN-Diode im gesperrten Zustand durch einen hochohmigen Schalter von ihrer Stromversorgung zu trennen. Hierbei spannt sich die PIN-Diode durch ihre Selbstgleichrichtung selbst auf die Hochfrequenzspitzenspannung vor, ohne daß eine extern zugeführte negative Vorspannung notwendig ist. Somit kann die unerwünschte Signalverzerrung nicht auftreten. Darüber hinaus werden die Oberwellenbildung und die Hochfrequenzdämpfung unterdrückt. Durch die erfindungsgemäße Lösung erübrigt sich die mit hohem Aufwand, hohen Kosten und nicht zuletzt mit erheblichem Raumbedarf verbundene Verwendung eines Spannungswandlers.

Eine ideale PIN-Diode funktioniert wie ein veränderbarer Widerstand, welcher durch Gleichstrom gesteuert wird. Eine reale PIN-Diode besitzt außerdem noch nichtlineare Eigenschaften, die von Frequenz und Amplitude des anliegenden Signals abhängig sind: Bei hohen Signalpegeln (also im "gesperrten" Zustand der Diode) richtet die PIN-Diode einen Teil der anliegenden Signalspannung gleich. Wenn nun für die gesperrte PIN-Diode ein DC-Pfad existiert (z. B. über die BIAS-Schaltung), fließt Gleichricht-Strom. Dies führt zum einen zu Oberwellenbildung in der Signalspannung und, da der Gleichrichtstrom für die PIN-Diode in Durchlaßrichtung liegt, zu einer Erniedrigung des PIN-Dioden-Widerstandes, und damit zu erhöhter Hochfrequenz-Dämpfung. Die erfindungsgemäße Lösung beinhaltet die hochohmige Unterbrechung des oben beschriebenen DC-Pfades (im Gegensatz zur aktiven Vorspannung der gesperrten Diode bei bisherigen Lösungen) sowie die "Speicherung" der von der PIN-Diode erzeugten negativen Spitzenspannung in dem Block-Kondensator C der HF-Verdrosselung (L und C).

Um den Bias-Widerstand in "AUS"-Zustand der PIN-Diode so hochohmig wie möglich zu machen, ist ein hochohmiger Schalter an die Spannungsversorgung angeschlossen.

Als solcher hochohmiger Schalter wird vorzugsweise ein Bipolar-Transistor verwendet, aber auch Feldeffekttransistoren und MOSFETs können eingesetzt werden, sofern ihre Restströme klein genug sind.

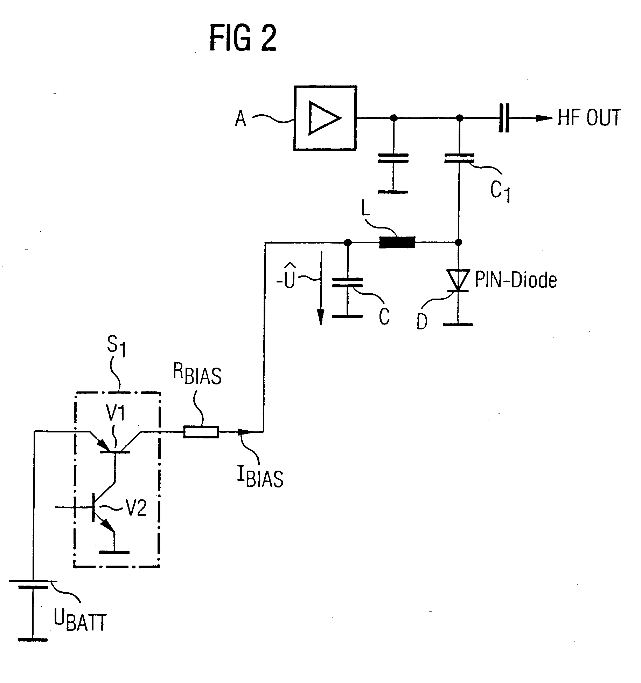

Weitere Vorteile und Zweckmäßigkeiten der Erfindung ergeben sich im übrigen aus den Unteransprüchen sowie der nachfolgenden Beschreibung eines Ausführungsbeispiels anhand der Figur 2. Es zeigen:
- Fig. 1: einen Schaltungsauszug einer PIN-Diodenansteuerung gemäß dem Stand der Technik,
- Fig. 2: ein Ausführungsbeispiel der erfindungsgemäßen PIN-Diodenschaltanordnung in der Leistungsverstärkerstufe eines Mobilfunktelefones.

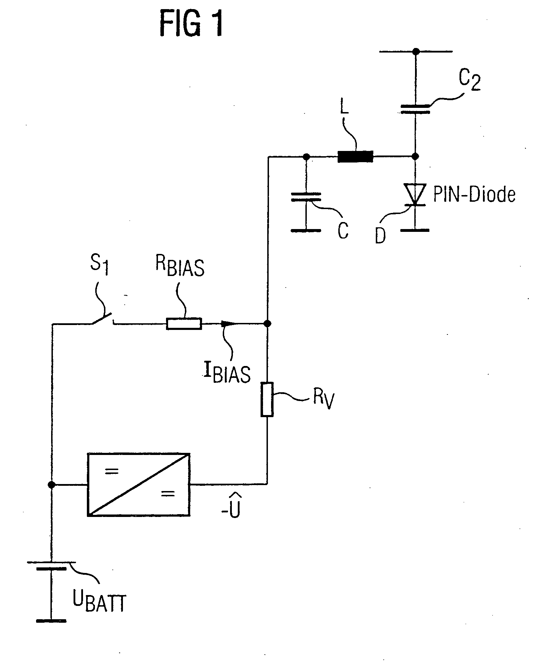

Fig. 1 zeigt die übliche PIN-Diodenansteuerung, bei der eine Diode D als "Shunt"-Schalter ausgeführt ist, die PIN-Diode D liegt HF-mäßig parallel zum Signalpfad. Die Diode D erhält im AUS-Zustand des Schalters S über den Widerstand Rv eine durch den Gleichspannungswandler erzeugte negative Sperrspannung -Û, die mindestens die Höhe der zu schaltenden Hochfrequenzspannung aufweist. Die PIN-Diode D ist dann im passiven Zustand gesperrt, und eine negative Spannung liegt an. Somit wird das Auftreten einer Signalverzerrung vermieden. Im "EIN"-Zustand des Schalters S1 fließt ein Strom I_{BIAS} durch die PIN-Diode, ihr Widerstand verringert sich und der Signalpfad wird über einen Kondensator C2 kurzgeschlossen.

Figur 2 zeigt - in einer die im Zusammenhang mit der Erfindung wesentlichen Funktionskomponenten hervorhebenden schematischen Darstellung - eine Leistungsverstärkerstufe eines Mobilfunktelefones mit einem HF-Leistungsverstärker A. Am Ausgang des HF-Leistungsverstärkers A und parallel zum Signalpfad ist ein Kondensator C1 elektronisch zugeschaltet, um das Anpassnetzwerk des HF-Leistungsverstärkers in einen anderen Frequenzbereich umzuschalten. Die PIN-Diode ist in Reihe mit dem Kondensator C1 geschaltet und mit der Kathode K auf Masse gelegt. Es ist weiterhin eine Stromversorgung U_{BATT} vorgesehen, an der emitter-seitig ein erster Transistor V1 angeschaltet ist. Der erste Transistor V1 ist kollektorseitig durch ein passives RLC-Filter parallel mit der PIN-Diode D geschaltet. Somit wirkt der Transistor V1 mit der PIN-Diode D als Spannungsteiler. Ein Kondensator C2 ist parallel zu einem Bias-Widerstand R_{Bias} geschaltet. Der Bias-Widerstand begrenzt den Strom je nach Höhe der Betriebsspannung. Der Kondensator C2 dient als Hochfrequenz-Blockkondensator. Es ist ein zweiter Transistor V2 vor-gesehen, bei dem der Sperrstrom zugleich Basisstrom von V1 ist, und der emitterseitig auf Masse gelegt ist. Durch den zweiten Transistor V2 wird eine Steuerspannung an die Basis des ersten Transistors V1 angelegt.

Über den Schalter S1, hier als Bipolar-Transistorpaar V1, V2 ausgeführt, wird die PIN-Diode eingeschaltet (R_{BIAS} begrenzt den Strom), um den Kondensator C1 HF-mäßig auf Masse zu legen. Um C1 aus dem Signalpfad herauszuschalten, braucht erfindungsgemäß nur der Schalter S1 "AUS"-geschaltet zu werden, eine negative Spannungsversorgung ist nicht nötig. Die PIN-Diode spannt sich selbst auf den negativen Scheitelwert der Signalspannung Û vor (meßbar an C2), Oberwellenbildung und Hochfrequenzdämpfung werden vermieden.

Die Erfindung ist nicht nur auf das beschriebene Ausführungsbeispiel beschränkt, sondern - jeweils unter Beachtung der konkreten Anforderungen - auch in einer Vielzahl von Abwandlungen ausführbar, was im Ermessen des Fachmanns liegt.

## Patentansprüche

1. PIN-Dioden-Schaltanordnung für eine Sende stufe mit einer PIN-Diode,
einem hochohmigen Schalter (S1), der die PIN-Diode (D) in ihrem gesperrten Zustand von ihrer Stromversorgung trennt, wobei sich die PIN-Diode (D) durch ihre Selbstgleichrichtung auf eine Gleich-Spannung, die etwa dem negativen Scheitelwert der Hochfrequenzspannung entspricht, vorspannt, um eine Oberwellenbildung und Hochfrequenzdämpfung zu unterdrücken,
**dadurch gekennzeichnet, dass**
die PIN-Diode (D) zum Signalpfad parallel geschaltet ist.

2. PIN-Dioden-Schaltanordnung nach Anspruch 1,
**dadurch gekennzeichnet**,
der hochohmige Schalter (S1) einen Bipolartransistor (V1) aufweist.

3. PIN-Dioden-Schaltanordnung nach Anspruch 1,
**dadurch gekennzeichnet,**
**daß** als hochohmiger Schalter ein Feldeffekttransistor, insbesondere MOSFET, vorgesehen ist

4. PIN-Dioden-Schaltanordnung nach einem der vorangehenden Ansprüche,
**dadurch gekennzeichnet, daß**
keine Hilfspannungsquelle für die PIN-Diode vorgesehen ist.

5. PIN-Dioden-Schaltanordnung nach einem der vorangehenden Ansprüche,
**dadurch gekennzeichnet,**
**daß** zwischen dem hochohmigen Schalter (S) und der PIN-Diode (D) ein passives Filter, insbesondere ein RLC-Filter vorgesehen ist, wobei ein Kondensator (C) als Ladungsspeicher für die selbst gleichgerichtete Gleichspannung der PIN-Diode wirkt.

6. Mobilfunk-Endgerät mit einer PIN-Dioden-Schaltanordnung nach einem der vorangehenden Ansprüche, welche als Frequenzbereichs-Umschalteinrichtung eines Hochfrequenz-Leistungs-Verstärkers dient.

7. Mobilfunk-Endgerät mit einer PIN-Dioden-Schaltanordnung nach einem der vorangehenden Ansprüche, welche als Antennen-Umschalteinrichtung dient.

## Claims

1. PIN diode switching arrangement for a transmitting step, having a PIN diode, and a high-resistance switch (S1) which disconnects the PIN diode (D) from its power supply in the blocked state thereof, as a result of its self-rectification the PIN diode (D) being pretensioned to a direct current voltage which approximately corresponds to the negative peak value of the high-frequency voltage in order to suppress harmonic wave formation and high-frequency damping,
**characterized in that**
the PIN diode (D) is connected in parallel to the signal path.

2. PIN diode switching arrangement according to claim 1,
**characterized in that**
the high-resistance switch (S1) has a bipolar transistor (V1).

3. PIN diode switching arrangement according to claim 1,
**characterized in that**
a field effect transistor, in particular a MOSFET, is provided as the high-resistance switch.

4. PIN diode switching arrangement according to one of the preceding claims,
**characterized in that**
no auxiliary voltage source is provided for the PIN diode.

5. PIN diode switching arrangement according to one of the preceding claims,
**characterized in that**
a passive filter, in particular an RLC filter, is provided between the high-resistance switch (S) and the PIN diode (D), a capacitor (C) acting as a charge store for the self-rectified direct current voltage of the PIN diode.

6. Mobile wireless terminal having a PIN diode switching arrangement according to one of the preceding claims, which is used as a frequency range switchover device of a high-frequency power amplifier.

7. Mobile wireless terminal having a PIN diode switching arrangement according to one of the preceding claims, which is used as an antenna switchover device.

## Revendications

1. Circuit à diode PIN pour étage émetteur, comprenant une diode PIN, un interrupteur à grande valeur ohmique (S1) qui, dans son état non conducteur, isole la diode PIN (D) de son alimentation, la diode PIN (D) se polarisant par son autoredressement sur une tension continue qui correspond sensiblement à la valeur de pic négative de la tension de la haute fréquence, afin d'éviter la formation d'une onde harmonique et l'atténuation de la haute fréquence,
**caractérisé par le fait que**
la diode PIN (D) est connectée en parallèle avec le chemin du signal.

2. Circuit à diode PIN selon la revendication 1,
**caractérisé par le fait que**
l'interrupteur à grande valeur ohmique (S1) présente un transistor bipolaire (V1).

3. Circuit à diode PIN selon la revendication 1,
**caractérisé par le fait qu'**
il comporte, comme interrupteur à grande valeur ohmique, un transistor à effet de champ, en particulier un MOSFET.

4. Circuit à diode PIN selon l'une des revendications précédentes,
**caractérisé par le fait qu'**
il ne comporte pas de source de tension auxiliaire pour la diode PIN.

5. Circuit à diode PIN selon l'une des revendications précédentes,
**caractérisé par le fait qu'**
il comporte, entre l'interrupteur à grande valeur ohmique (S) et la diode PIN (D), un filtre passif, en particulier un filtre RLC, un condensateur (C) jouant le rôle d'un accumulateur de charge pour la tension continue auto-redressée de la diode PIN.

6. Terminal de téléphonie mobile comportant un circuit à diode PIN selon l'une des revendications précédentes, qui est utilisé comme dispositif de commutation dans la plage de fréquences d'un amplificateur de puissance à haute fréquence.

7. Terminal de téléphonie mobile comportant un circuit à diode PIN selon l'une des revendications précédentes, qui est utilisé comme dispositif de commutation d'antenne.
